Europäisches Patentamt

European Patent Office

Office européen des brevets

(11) Numéro de publication: **0 412 026 A1**

## (12) DEMANDE DE BREVET EUROPEEN

(21) Numéro de dépôt: 90420350.2

(22) Date de dépôt: **20.07.90**

(51) Int. Cl.5: **B41M 5/165, G03F 7/00**

(30) Priorité: **02.08.89 FR 8910630**

(43) Date de publication de la demande:
**06.02.91 Bulletin 91/06**

(84) Etats contractants désignés:
**AT BE CH DE DK ES FR GB GR IT LI LU NL SE**

(71) Demandeur: **SOCIETE ANONYME DES PAPETERIES DE CLAIREFONTAINE**

**F-88480 Etival Clairefontaine(FR)**

(72) Inventeur: **Pouyet, Bernard**
**501 avenue du 8 mai**
**F-69300 Caluire(FR)**

(74) Mandataire: **Guerre, Dominique et al**
**Cabinet Germain et Maureau 20 Boulevard**
**Eugène Deruelle BP 3011**
**F-69392 Lyon Cédex 03(FR)**

(54) **Procédé et dispositif de reproduction mettant en oeuvre une feuille de reproduction sensible à la lumière.**

(57) Feuille (1) de reproduction sensible à une radiation actinique, comportant un substrat (2) en forme de feuille, un revêtement sensible (3) sur au moins une face du substrat, comprenant des micro-capsules (4), chaque micro-capsule comportant une enveloppe (5) étanche susceptible de se rompre sous l'action d'un agent extérieur, et un milieu intérieur (6) liquide contenant un composé révélateur, actif vis-à-vis de la reproduction, caractérisée en ce qu'au moins l'un des composants de la micro-capsule, à savoir l'enveloppe (5), le milieu intérieur (6), et éventuellement le composé révélateur, est susceptible d'absorber et de s'échauffer sous l'action d'un rayonnement électro-magnétique hyperfréquence, dit rayonnement micro-onde, et de conduire par son échauffement à la rupture de la même micro-capsule, avec libération vers l'extérieur du composé révélateur, moyennant quoi le rayonnement micro-onde peut être utilisé comme agent révélateur de la feuille de reproduction.

FIG.1

EP 0 412 026 A1

## PROCEDE ET DISPOSITIF DE REPRODUCTION, METTANT EN OEUVRE UNE FEUILLE DE REPRODUCTION SENSIBLE A LA LUMIERE

La présente invention concerne la reproduction d'une image sur un support, qu'il s'agisse des techniques s'apparentant à la photographie, ou des techniques s'apparentant à la photocopie, ou à la reprographie d'originaux, et ce aussi bien en noir et blanc, c'est-à-dire de manière monochrome, qu'en couleur, c'est-à-dire de manière polychrome.

Selon les documents GB-A-2 113 860, FR-A-2 516 269, et EP-A-164 931, on a décrit et proposé une feuille de reproduction sensible à une radiation actinique, préférentiellement dans le domaine du spectre visible, ainsi qu'à la pression, comportant :
- un substrat en forme de feuille, par exemple un papier
- un revêtement sensible à ladite radiation actinique, comme décrit ci-après, disposé sur au moins une face de substrat, ce revêtement comprenant des micro-capsules synthétiques ; chaque micro-capsule comporte premièrement, une enveloppe étanche, par exemple en polymère organique, susceptible de se rompre sous l'action d'un agent extérieur, en l'occurrence une pression mécanique appliquée par pincement ou calandrage, deuxièmement un milieu intérieur liquide, par exemple une huile, troisièmement un agent colorant ou composé révélateur contenu dans le milieu intérieur, en l'occurrence dissout dans ce dernier, à savoir un précurseur de coloration, susceptible de réagir chimiquement avec un composé complémentaire, tel qu'un agent chromogène, présent sur le même support ou sur un support de transfert ou développement, et quatrièmement un composé photo-durcissable sous l'action de la radiation actinique, contenu par le même milieu intérieur, susceptible d'accroître la résistance mécanique de l'enveloppe, et/ou d'immobiliser l'agent colorant par augmentation de la viscosité du milieu intérieur

Les micro-capsules sont obtenues de manière traditionnelle, selon les techniques de micro-encapsulation par polymérisation, largement décrites dans la littérature pertinente.

Une telle feuille de reproduction est utilisée selon le procédé de reproduction décrit ci-après :
- avec une source de la radiation actinique, on projette l'image d'un original à reproduire sur la feuille, et plus précisément sur le revête ment sensible ; on obtient donc une insolation ou exposition de ce dernier, différenciée dans le plan de la feuille ; dans les zones exposées, le composé durcissable augmente la résistance mécanique à l'écrasement des micro-capsules et/ou augmente la viscosité du milieu intérieur; dans les zones non exposées, le composé durcissable n'est pas modifié

- on soumet mécaniquement, par exemple entre deux rouleaux, la feuille de reproduction ainsi exposée, à un écrasement ; ce dernier fait éclater préférentiellement les micro-capsules non exposées, c'est-à-dire celles dont l'enveloppe n'a pas été renforcée, par différence aux micro-capsules exposées ; l'agent colorant est libéré à l'extérieur des micro-capsules exposées, pour réagir avec le composant complémentaire ou agent chromogène, sur le même substrat, ou un support de transfert ou développement, et donner un produit coloré matérialisant l'image de l'original.

Une feuille de reproduction telle que précédemment décrite, et le procédé de reproduction qui lui correspond présentent les inconvénients importants suivants.

L'éclatement par voie mécanique des micro-capsules requiert l'application d'une pression régulière, et homogène dans le plan de la feuille de reproduction. A cet égard, d'une part ceci requiert l'usage d'un équipement de compression de précision, et un réglage fin, et d'autre part, l'irrégularité du support, à l'échelle des micro-capsules, en creux et en bosses, contrarie l'application d'une pression homogène dans le plan de la feuille. Tout ceci aboutit donc à un éclatement des micro-capsules, erratique quant à sa localisation dans le plan de la feuille, et par conséquent impropre à la reproduction d'une image précise, laquelle requiert un éclatement exactement aux endroits non exposés.

Cet éclatement par voie mécanique n'est en pratique opérationnel qu'avec des micro-capsules présentant une certaine taille, par exemple supérieures à 100 $\mu$m. Des micro-capsules ayant des dimensions aussi importantes peuvent être incompatibles avec le procédé ou le dispositif de reproduction employés. Il apparaît de toutes façons souhaitable d'utiliser des micro-capsules aussi fines que possible, de manière à avoir une reproduction fine et précise.

Pour terminer, l'épaisseur de l'enveloppe des micro-capsules peut varier de manière significative d'un individu à un autre. Or, toutes les capsules sont soumises unitairement par l'extérieur à la même compres sion. Il en résulte que certaines capsules éclateront, d'autres pas, et ceci de manière toujours erratique et incontrôlée, ce qui nuit à la maîtrise et à la précision du processus de reproduction.

La présente invention a pour objet de remédier à ces inconvénients.

L'invention a pour objet une feuille de reproduction dont les micro-capsules peuvent être éclatées de manière exhaustive, quelles que soient les irrégularités ou imperfections du substrat/support, ou de leurs différents composants.

L'invention a également pour objet une feuille de reproduction dont les micro-capsules peuvent être de tailles relativement fines, par exemple de l'ordre de 5 à 10 µm, mais peuvent néanmoins être éclatées.

L'invention a également pour objet une feuille de reproduction permettant de reproduire une image en couleur d'un original.

Selon la présente invention, au moins l'un des composants des micro-capsules, à savoir l'enveloppe, le milieu intérieur, et le composé révélateur, est susceptible d'absorber et de s'échauffer sous l'action d'un rayonnement électro-magnétique hyper-fréquence, dit rayonnement micro-onde. Cet échauffement conduit à la rupture des mêmes micro-capsules, avec libération vers l'extérieur du composé révélateur. Par conséquent selon l'invention, le rayonnement micro-onde est utilisé comme agent révélateur de la feuille de reproduction.

Un tel procédé apporte en outre les avantages déterminants suivants.

La nature endogène, c'est-à-dire de l'intérieur vers l'extérieur, de l'action des micro-ondes, provoquant l'éclatement des micro-capsules, affranchit le processus d'éclatement de toutes les contraintes traditionnelles et extérieures, liées à la taille des capsules, leurs régularités, et leurs dimensions unitaires, mais aussi liées à l'usage de moyens externes et mécaniques, d'éclatement.

L'éclatement sous l'action des micro-ondes se révèle être très rapide, quasi-instantané, et est alors compatible avec l'automatisation ou mécanisation d'une machine ou dispositif de reproduction, tel qu'un photocopieur.

L'action des micro-ondes évite de recourir à tout solvant, ou autres matières organiques liquides, polluantes, par exemple pour dissoudre l'enveloppe des micro-capsules. Il s'agit donc d'un procédé pouvant être mis en oeuvre "à sec", ce qui aussi est largement compatible avec un appareil de reprographie.

L'action des micro-ondes est sélective, et n'altère pas les propriétés ou caractéristiques des composants des micro-capsules, autres que ceux absorbant le rayonnement hyper-fréquence. Ceci permet si besoin est de préserver les propriétés de l'agent colorant ou du composé révélateur.

Avec l'invention, on peut régler la puissance des micro-ondes de façon à moduler l'éclatement des micro-capsules.

Au total, l'invention offre un procédé de reproduction, facile à mettre en oeuvre, et relativement peu coûteux quant aux moyens techniques qui doivent lui être associés.

Sous un autre aspect, et indépendamment de l'utilisation d'un rayonnement micro-onde pour rompre les micro-capsules, la présente invention propose également un nouveau système de reproduction, consistant à incorporer dans le milieu intérieur des micro-capsules, à titre de composé révélateur, un agent colorant complémentaire du composé photo-polymérisable, ou inversement, c'est-à-dire :

- un agent colorant, d'une part activé par absorption d'une première radiation actinique ou première bande de radiations actiniques, par exemple une première couleur fondamentale de la lumière visible, telle que le bleu, et d'autre part désactivé par absorption d'une deuxième radiation actinique, ou deuxième bande de radiations actiniques, par exemple au moins une autre couleur fondamentale de la lumière visible, complémentaire à la première couleur fondamentale, telle que le vert ou le jaune

- et un composé photopolymérisable, activé sous l'effet de l'autre radiation actinique au moins, et inactivé sous l'effet de la première radiation actinique.

Une telle caractéristique permet une reproduction polychrome directe, c'est-à-dire sans réaction chimique complémentaire avec un agent chromogène, et sans transfert d'une image latente sur un papier distinct de reproduction. Il suffit de disposer sur le support de la feuille trois ensembles de micro-capsules monochromes, correspondant à trois couleurs fondamentales respectivement, par exemple, le bleu, le rouge et le jaune. Ces trois ensembles peuvent être disposés selon un seul et même revêtement, c'est-à-dire mélangés de manière intime et homogène sur une même couche, ou selon trois revêtements superposés sur le substrat, correspondants aux trois ensembles monochromes respectivement. Le milieu interne des micro-capsules d'un ensemble monochrome donné contient un couple donné agent colorant/composé photo-polymérisable, l'agent colorant étant activé par une couleur fondamentale donnée, par exemple la couleur bleue, et désactivé par les autres couleurs fondamentales, à savoir le jaune et le vert, et le composé photo-polymérisable se polymérisant de manière sélective sous éclairement d'au moins une autre couleur fondamentale, à savoir le jaune et/ou le vert. Par conséquent, aux trois ensembles donnés, correspondent trois couples respectivement différents d'agents colorants-composés polymérisables.

Bien entendu, selon la description précédente, un couple donné agent colorant/composé photopolymérisable permet d'obtenir une reproduction dans une couleur monochrome, par exemple en noir et en blanc.

Si une feuille de reproduction telle que décrite précédemment comprend des agents colorants encapsulés dans des micro-capsules sensibles à un rayonnement micro-ondes, alors l'exposition de la feuille insolée à un tel rayonnement permet de révéler ou développer directement une image couleur.

Les termes suivants, utilisés dans la présente description et dans les revendications, doivent être compris selon les acceptions suivantes.

Par "radiation actinique", on entend toute radiation du spectre électro-magnétique, notamment visible, ultra-violet et infra-rouge, rayonnement X, susceptible d'activer l'agent colorant et/ou d'initier directement ou indirectement la polymérisation du composé photo-polymérisable.

Par "substrat", on entend tout matériau ayant la forme d'une feuille, c'est-à-dire dont l'épaisseur est substantiellement inférieure aux deux autres dimensions, à savoir largeur et longueur. Les matériaux pouvant être retenus sont très divers ; il peut s'agir de papier, d'un matériau plastique, d'un tissu, d'un non-tissé, etc... Ce substrat reçoit un revêtement comprenant les micro-capsules, avec ou sans liant, et est adapté en conséquence, soit par le choix du matériau, soit par un traitement approprié et préalable.

Par "revêtement sensible", on entend un revêtement susceptible d'être modifié quant à au moins l'une de ses propriétés intrinsèques, par l'absorption ou la réception d'un rayonnement actinique. Par insolation ou exposition différenciée dans le plan d'un tel revêtement, correspondant par exemple à l'image d'un original, on obtiendra un revêtement modifié localement quant à ladite propriété intrinsèque. Les modifications locales, si elles ne sont pas déjà visibles à l'oeil nu, peuvent être ultérieurement révélées, c'est-à-dire rendues visibles, par tout procédé approprié, physique et/ou chimique, pour obtenir une reproduction de l'original.

Selon la présente invention, ce revêtement est constitué pour l'essentiel par les micro-capsules définies ci-après, incorporées ou liées au substrat par tout moyen approprié, par exemple un liant. Ce revêtement peut être constitué notamment par des micro-capsules couchées sur un papier. Bien entendu, le revêtement peut comprendre d'autres corps que les micro-capsules, par exemple une charge, un agent de protection, etc...

Par "micro-capsules", on entend des vésicules fermées, par exemple sphériques, creuses à l'intérieur, ayant différentes dimensions s'échelonnant de quelques μm à quelques millimètres. Ces micro-capsules sont obtenues selon les techniques traditionnelles de micro-encapsulation, bien décrites dans la littérature, et par exemple dans :
- le document FR-A-2 548 046
- le document BE-A-796 746
- les documents US-C-3 790 497, 3 577 515, 3 173 878

- le "Journal of Micro-Encapsulation", Vol.1, N°1, Microcapsules processing and technology - Asaji Kondo.

L'enveloppe de ces capsules, transparente à la radiation actinique mise en oeuvre dans le processus de reproduction, est obtenue généralement par polymérisation d'un monomère, à l'interface en milieu dispersé de deux phases distinctes, dont l'une est constituée par le milieu intérieur et les différents composés à encapsuler, en général sous forte agitation. Les voies chimiques de polymérisation peuvent être traditionnelles, par exemple radicalaires, ioniques, polyaddition, polycondensation, etc... L'enveloppe polymère obtenue peut être ou non élastique. Toutes sortes de polymères peuvent être retenus, par exemple l'EMA, copolymère éthylène-anhydridre maléïque, l'éthyl-cellulose, un polyamide, une polyurée, etc...

Par "milieu intérieur", on entend la substance liquide ou fluide, contenue par les micro-capsules. Il peut s'agir d'une substance distincte des composés révélateur et photo-polymérisable, actifs dans le processus de reproduction ou révélation ; dans ce cas, les composés du système de reproduction peuvent être en solution, suspension, dispersion ou émulsion dans ladite substance. Mais ces composés du système de reproduction peuvent former à eux seuls le milieu intérieur, par exemple sous forme d'un mélange de liquides.

Par "composé révélateur", on entend un corps, par exemple un agent colorant, qui une fois libéré de la micro-capsule est susceptible d'être perçu à l'oeil nu, directement, ou indirectement, par exemple après un traitement approprié, notamment chimique.

Par "agent colorant", on entend
- tout composé visible au perçu à l'oeil nu, sous la forme d'une couleur, y compris la couleur blanche
- tout composé susceptible par action chimique et/ou physique, de révéler une couleur, visible ou perçue à l'oeil nu ; si le composé présente une couleur originelle, la couleur révélée est différente de cette dernière
- tout composé tel qu'un précurseur de coloration, susceptible de réagir chimiquement avec un composé complémentaire, tel qu'un agent chromogène, présent sur le même support ou sur un support de transfert ou développement, pour générer un produit, visible ou perçu à l'oeil nu ; si le composé de départ et/ou le composé complémentaire présentent une couleur originelle, le produit coloré obtenu présente une couleur différente de cette dernière.

Par "activer" l'agent colorant , on entend l'action physique obtenue par absorption d'une radiation actinique d'excitation, consistant à préserver la coloration de l'agent colorant, ou à décolorer ce dernier. Inversement, "désactiver" l'agent colorant consiste, sous l'effet d'une radiation actinique différente de la radiation d'excitation, ou en l'absence de cette dernière, à décolorer l'agent colorant, ou à préserver sa coloration.

Cet agent colorant doit pouvoir être mis en suspension ou solution dans le milieu interne des micro-capsules.

Par "rayonnement micro-onde", on entend un rayonnement électromagnétique dont les longueurs d'onde sont inférieures à 1 cm, ou dont les fréquences sont supérieures à 1 GHz. La technologie propre à la génération et à l'utilisation de ces rayonnements est par exemple décrite dans :
- H.F Mark, D.F Othmer et al : "Kirk-Othmer Encyclopedia of Chemical Technology, Edition 3, N° 15, 1989, Wiley and Sons, New York, USA, page 505 à page 521.

Par "matériau polaire", ou "groupement fonctionnel polaire", on entend tout agencement d'atomes polarisé électriquement en raison de la nature chimique desdits atomes, et se comportant comme un dipole lorsqu'ils sont placés entre deux électrodes de polarité opposée. On sait qu'en présence de micro-ondes, de tels agencements sont mis en mouvement, notamment en rotation, ce qui conduit à l'échauffement du matériau correspondant.

Par "composé photo-polymérisable", on entend notamment tout système chimique comprenant un monomère, ou un oligomère, ou un polymère, un agent de photo-polymérisation ou photo-réticulation sous rayonnement actinique, ou photo-initiateur, et un agent de transfert électronique ou "relais". Ce système chimique doit pouvoir être mis en suspension ou solution dans le milieu interne des micro-capsules. Comme monomères, on peut utiliser les composés insaturés comme l'éthylène.

S'agissant du couple agent colorant/composé photo-polymérisable introduit précédemment en ce qui concerne une reproduction polychrome ou monochrome, son fonctionnement peut être le suivant :
- par insolation des micro-capsules, l'agent colorant absorbe l'énergie lumineuse incidente, et se désactive, par exemple passe à l'état exité où il est incolore
- ce faisant, l'agent colorant transmet son énergie à l'agent de photo-polymérisation, qui initie la polymérisation du monomère, par transfert d'énergie au niveau du relais
- sous l'effet de l'irradiation, et à condition que la longueur d'onde d'éclairement corresponde à la zone de désactivation ou absorption du colorant, la micro-capsule est alors devenue dure et incolore.

A titre d'exemple, les produits suivants peuvent être retenus :
- agents colorants : bleu de méthylène, éosine, colorants Capelle rouge, jaune et bleu
- monomère ou polymère (soluble dans l'eau) : acrylamide
- photo-initiateur : 1 phényl 1-2 propanedione 2-(0 - ethoxycarbonyl) oxime
- relais : sel de sodium de l'acide p-toluène sulfinique à 99 %

Comme agent de photo-polymérisation, on peut utiliser des composés péracides organiques ou inorganiques comme le peroxyde de diacyle, le peroxyle de sulfuryle, le peroxydicarbonate, etc...

Pour que les micro-capsules selon l'invention absorbent le rayonnement micro-onde, et s'échauffent sous l'effet de ce dernier, différentes solutions peuvent être retenues :
- ce peut être tout d'abord l'enveloppe des micro-capsules qui absorbe ce rayonnement, par exemple si celle-ci est faite en un matériau chimique polaire
- ce peut être ensuite le milieu interne des micro-capsules qui absorbe ce même rayonnement, en particulier s'il est constitué par de l'eau, des corps organiques polaires, tels que des alcools, des amines, et des acides, ainsi que des métaux divisés en suspension, par exemple
- pour terminer, ce peut être aussi le composé révélateur qui absorbe le rayonnement micro-onde, par exemple s'il s'agit d'un corps chimique comportant des groupements fonctionnels polaires, par exemple alcools, amines, et acides ; mais le composé révélateur peut aussi absorber le rayonnement micro-onde, s'il s'agit d'un pigment métallique.

La présente invention est maintenant décrite par référence aux dessins annexés dans lesquels :
- la figure 1 représente de manière schématique, et à échelle agrandie une feuille de reproduction selon l'invention
- la figure 2 représente la phase d'insolation ou d'exposition d'une feuille selon l'invention, dans un dispositif approprié
- la figure 3 représente la phase de développement ou révélation de la même feuille, dans un dispositif approprié, après insolation selon la figure 2, cette phase de développement étant accomplie en présence d'un rayonnement micro-onde.

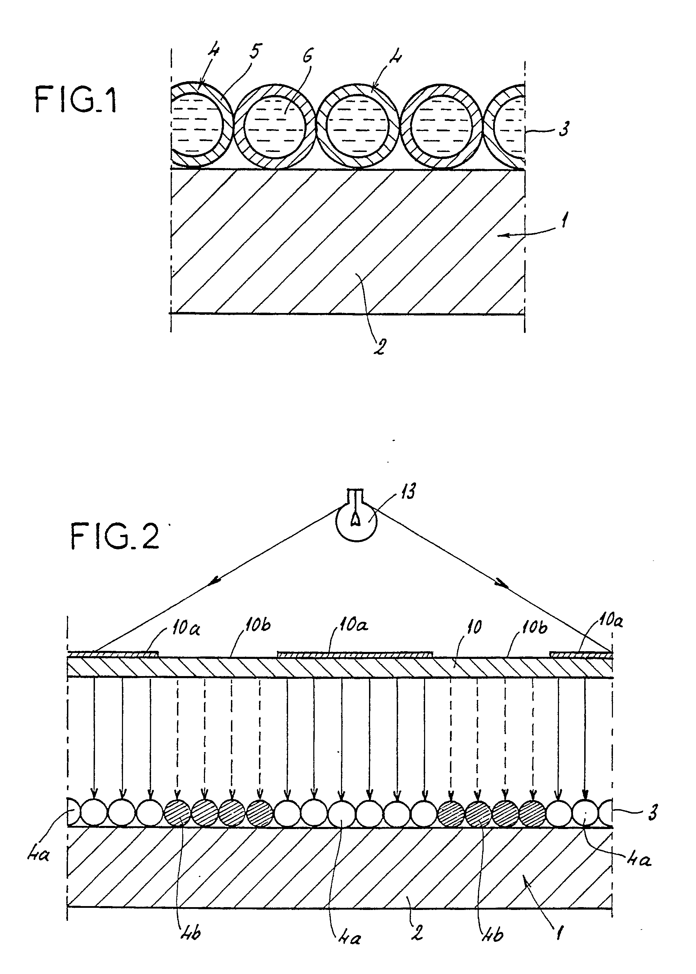

Conformément à la figure 1, la feuille de reproduction repérée par la référence numérique 1 comporte un substrat 2 en forme de feuille, par exemple une nappe de papier, un revêtement sensible 3 disposé sur l'une des faces du substrat précité, comprenant des micro-capsules 4 selon l'invention. Chaque micro-capsule comporte une enveloppe étanche 5, et un milieu intérieur liquide 6 comprenant un composé révélateur, actif vis-a-vis de la reproduction, à savoir un agent colorant tel que défini précédemment, mais aussi un composé photo-polymérisable sous l'action d'un rayonnement actinique, par exemple une lumière visible ou infra-rouge.

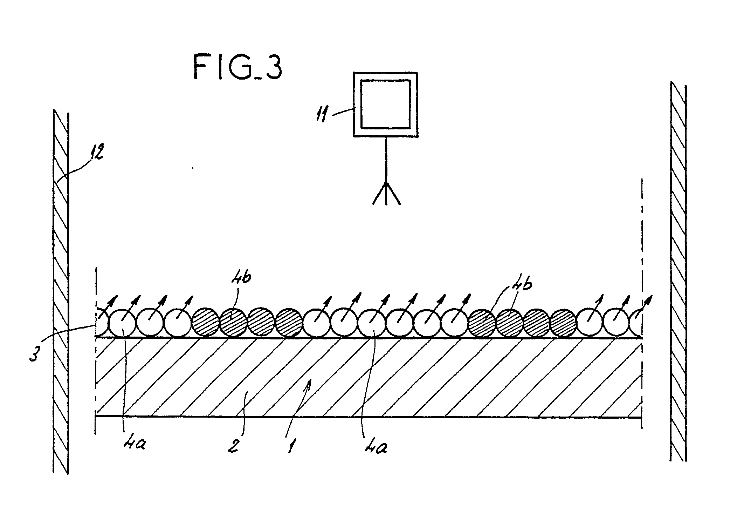

Le procédé de reproduction pouvant être mis en oeuvre selon l'invention est illustré aux Figures 2 et 3.

Grâce à une source lumineuse 13 polychromatique, et à partir d'un original 10 à reproduire, on obtient par lumière réfléchie ou transmise par ledit original, une image comportant par exemple des faisceaux colorés en bleu (couleur fondamentale), résultant de l'absorption dans les zones 10a de l'original des autres couleurs fondamentales, et des faisceaux d'une autre couleur, correspondant aux zones 10b du même original 10, n'ayant pas absorbé les couleurs verte et jaune. Ces deux types de faisceaux sont montrés à la Figure 2, respectivement par des flèches en traits pleins et par des flèches en traits pointillés.

Dans les zones du revêtement 3, éclairées par les faisceaux de couleur bleue, l'agent colorant contenu dans les capsules 4a, est activé, c'est-à-dire qu'il n'est pas décoloré par le rayonnement reçu. Dans ces mêmes zones, et pour les mêmes capsules, le composé photo-polymérisable n'est pas activé, de telle sorte que ces capsules 4a ne sont pas durcies. Au contraire, dans les zones du revêtement 3, éclairées par les faisceaux autres que de couleur bleue, correspondant aux capsules 4b, d'une part l'agent colorant contenu dans ces dernières est désactivé, c'est-à-dire décoloré, et d'autre part le composé photo-polymérisable est polymérisé sous l'effet du rayonnement reçu, de telle sorte que les capsules 4b sont rigidifiées. Dans l'étape suivante selon la Figure 3, la feuille de reproduction 1 est soumise dans une cavité 12 à un rayonnement micro-onde généré par un magnétron 11 par exemple. Les capsules 4a vont se rompre sous l'effet de ce rayonnement, et libérer l'agent colorant activé, c'est-à-dire demeuré intact, tandis que les capsules 4b, de couleur blanche, puisque décolorées dans l'étape précédente, ne vont pas se rompre et demeurer intactes. Au total, après développement sous rayonnement micro-onde, on obtiendra donc un revêtement 3 présentant des plages colorées en bleu, correspondant aux capsules 4a, et des plages blanches, correspondant aux capsules 4b.

Au plan expérimental, on a tout d'abord recherché et mis au point différentes techniques de micro-encapsulation, conduisant à des micro-capsules perméables à un rayonnement micro-ondes.

Trois techniques retenues sont répertoriées ci-après.

## 1 - PROCEDE A L'EMA

### Principe

Cette méthode utilise un polymère particulier : l'EMA, copolymère éthylène-anhydride maléique qui dans une certaine zone de pH interréagit avec une résine mélamine-formol pour former la paroi des micro-capsules.

### Manipulation

Dans un réacteur en verre, on agite vigoureusement en chauffant une solution aqueuse (480g) contenant de la soude à 50 % (11,62g), ainsi que le copolymère EMA (15g). Lorsque le polymère est totalement solubilisé (solution translucide), la solution est refroidie à 30° C. Le pH doit alors être compris entre 5,8 et 6,2. On ajoute alors successivement, sous agitation :
- de la n-butylamine (8,3 g)
le pH est alors compris entre 10,5 et 11
- une résine mélamine-formol
(poids à 45 % : 51,1 g)
- de l'acide acétique jusqu'à l'obtention d'un pH inférieur à 4,5.

L'agitation est stoppée. La solution se présente sous la forme d'un lait. La solution à encapsuler (280 g) est ajoutée à la solution précédente. Celle-ci comporte le produit à encapsuler solubilisé dans un solvant adéquat. Après décantation et disparition des mousses, l'opération d'encapsulation peut avoir lieu. La turbine microdisperseuse est mise au maximum de sa puissance (12000 t/mn) pendant 10 mn.

La solidification des parois des capsules se fait ensuite par chauffage de l'émulsion à 95° C pendant une heure.

La neutralisation de l'excès d'acidité de l'émulsion se fait après refroidissement à 30° C avec de l'ammoniac dilué jusqu'à pH 7.

## CONCLUSION

Cette technique d'encapsulation est simple et rapide. Elle permet l'obtention de capsules régulières et assez solides. Ces capsules présentent un diamètre de 20 à 50 microns, et la distribution des tailles à l'intérieur d'une même solution est assez homogène.

## 2 - PROCEDE PAR POLYMERISATION INTERFACIALE

### Principe

La micro-encapsulation par polymérisation interfaciale se fait en général entre une amine RNH2 et un acide R′COOH pour donner une amide RCONHR′. Ce processus est appelé polymérisation interfaciale simple.

Il est possible d'employer un triacide ou une triamine afin de consolider la liaison ainsi formée, en créant un réseau trifonctionnel. Il s'agit de la polymérisation interfaciale complexe.

Dans le but de l'application des micro-ondes selon l'invention, on retient la polymérisation interfaciale complexe.

Mode opératoire

On prépare les trois solutions suivantes:

Solution 1 :

- 115 ml d'huile minérale (type vaseline)
- 50 ml de solvant CC14

Solution 2 :

- 0,075 g d'éthylène diamine
- 0,075 g de diéthylène triamine
- 0,5 g de carbonate de soduim hydraté
- 6,5 ml d'eau (+ agent colorant)

Solution 3 :

- 0,021 g de chlorure de sébacoyle
- 0,04 g de trichlorure de trimésoyle
- 12,5 g de CC14
- 12,5 g de pentane.

On verse la solution 2 dans la solution 1 sous agitation rapide pendant 1 minute, à température ambiante. On ajoute alors la solution 3 sous agitation de type ancre pendant 1 heure, à température ambiante.

Afin d'obtenir des micro-capsules non agglomérées, il est important de maintenir constants les rapports éthylène diamine/chlorure de sébacoyle = 3,5 et diéthylène triamine/trichlorure de trimésoyle = 2. Toutefois, on peut faire varier les quantités dans des rapports de 1 à 10. On obtient alors des murs de polymères plus ou moins importants, et les micro-capsules présentent naturellement des aspects différents à l'observation au microscope optique.

**CONCLUSION**

Ce mode d'encapsulation donne des résultats très satisfaisants pour l'encapsulation de substances aqueuses selon l'invention. On obtient en effet des capsules non agglomérées qui présentent une paroi hermétique mais transparente. Il semble que l'on puisse moduler le diamètre des capsules, aussi bien que l'épaisseur des parois, en fonction de l'application.

**3 - PROCEDE PAR POLYCONDENSATION INTERFACIALE**

Principe

Selon le processus chimique
diamine ou diisocyanate ou = Polyurée
polyamine + polyisocyanate

On réalise l'hydrolyse d'un isocyanate pour former une amine qui à son tour réagit avec le même isocyanate pour former une polyurée.

Manipulation

On prépare la phase dispersante par dissolution et homogénéi sation de :
- 400 cm3 de xylène
- 10 g de 22-éthyl-monoanhydrosorbitol-isocyanate trioléate (émulsifiant oléophile)
- 12 g d'un polyméthylène-polyphényl-isocyanate commercialisé par la société Bayer sous l'appellation de Desmodur R 44 V 20, et dont la fonctionnalité moyenne en groupes NCO par mole est de 2,7.

On émulsionne 70 cm3 d'eau distillée dans le mélange préparé ci-avant, au moyen d'une turbine tournant à 4500 t/mn. Au bout de 40 secondes on obtient une émulsion stable. La turbine est arrêtée et l'essai se poursuit sous agitation de type ancre.

On laisse poursuivre la réaction pendant 3 heures à température ambiante. On laisse ensuite décanter. Les micro-capsules sont filtrées puis lavées au cyclohexane, puis par un mélange 50/50 en poids d'eau et de 22 diéthyl-monoanhydrosorbitol monolaurate, puis par de l'eau pure.

Des variantes sont apportées à ce mode opératoire, avec la possibilité de stabiliser l'émulsion avec de la carboxyméthylcellulose ou du silicate de soude (à un pH donné).

**CONCLUSION**

Cette méthode permet d'obtenir des micro-capsules de type eau dans huile, de très faible diamètre (5 à 10 microns), ayant une paroi d'épaisseur convenable, c'est-à-dire permettant une bonne imperméabilisation des micro-capsules.

On a ensuite recherché un composé photo-polymérisable adéquat, selon la procédure suivante :

### ESSAIS

Les matières premières testées sont les suivantes :
- monomère : acrylamide (soluble dans l'eau)
- photoinitiateur : 1 phényl 1-2 propanédione 2- (O-éthoxycarbonyl) oxime, benzophénones, thioxanthones combinées à une amine tertiaire
- relais : sel de sodium de l'acide p-toluène sulfinique à 99 %.

### CONCLUSION

Les benzophénones et thioxanthones apparaissent à priori adaptées aux applications selon l'invention.

On a pour terminer, procédé aux expériences suivantes :

Exemple 1

On réalise, par polymérisation interfaciale, des micro-capsules contenant de l'eau (milieu interne), de l'éosine (agent colorant), du toluène sulfonate (initiateur de la photo-polymérisation), du thioxanthone (matière photo-polymérisable), de l'acrylamide (polymère de l'enveloppe).

Ces capsules sont placées en suspension organique, et déposées sur une lamelle simulant un support tel que du papier.

La lamelle est placée au centre d'une cavité 12 de type TE 10, et irradiée par un générateur radio-électrique magnétron 11 de 2.45 Giga Hertz, selon la figure 2. Le fonctionnement de l'émetteur se fait en mode Pulsé. La puissance d'irradiation est de 200 Watts.

On observe au microscope optique un éclatement des micro-capsules, libérant l'éosine.

Exemple 2

On réalise, par polymérisation interfaciale, des micro-capsules contenant du formamide (polymère de l'enveloppe), du bleu de méthylène (agent colorant), du toluène sulfonate (initiateur de photo-polymérisation), du thioxanthone (matière photo-polymérisable), de l'acrylamide.

Ces capsules sont placées en solution aqueuse, dans les mêmes conditions que précédemment, c'est-à-dire sous rayonnement micro-onde, mais à une puissance inférieure de 150 Watts.

On constate que cette puissance suffit à l'éclatement de l'ensemble des capsules concernées.

### Revendications

1 - Feuille (1) de reproduction sensible à une radiation actinique, comportant un substrat (2) en forme de feuille, un revêtement sensible (3) sur au moins une face du substrat, comprenant des micro-capsules (4), chaque micro-capsule comportant une enveloppe (5) étanche susceptible de se rompre sous l'action d'un agent extérieur, et un milieu intérieur (6) liquide contenant un composé révélateur, actif vis-à-vis de la reproduction, caractérisée en ce qu'au moins l'un des composants de la micro-capsule, à savoir l'enveloppe (5), le milieu intérieur (6), et éventuellement le composé révélateur, est susceptible d'absorber et de s'échauffer sous l'action d'un rayonnement électro-magnétique hyperfréquence, dit rayonnement micro-onde, et de conduire par son échauffement à la rupture de la même micro-capsule, avec libération vers l'extérieur du composé révélateur, moyennant quoi le rayonnement micro-onde peut être utilisé comme agent révélateur de la feuille de reproduction.

2 - Feuille selon la revendication 1, caractérisée en ce que le composant absorbant le rayonnement micro-onde est l'enveloppe (5) des micro-capsules.

3 - Feuille selon la revendication 2, caractérisée en ce que l'enveloppe (5) est faîte en un matériau chimique polaire

4 - Feuille selon la revendication 1, caractérisée en ce que le composant absorbant le rayonnement micro-onde est le milieu interne (5) des micro-capsules.

5 - Feuille selon la revendication 4, caractérisée en ce que le milieu interne (5) comprend au moins l'un des composés suivants:
- de l'eau
- des corps organiques polaires, tels qu'alcools, amines, acides
- des métaux divisés

6 - Feuille selon la revendication 1, caractérisée en ce que le composant absorbant le rayonnement micro-onde est le composé révélateur.

7 - Feuille selon la revendication 6, caractérisée en ce que le composé révélateur est un corps chimique comportant des groupements fonctionnels polaires, tels qu'alcools, amines, acides.

8 - Feuille selon la revendication 6, caractérisée en ce que le composé révélateur est un pigment métallique.

9 - Feuille selon l'une quelconque des revendications 1 à 8, caractérisée en ce que le milieu intérieur comprend :
- un agent colorant, d'une part activé par absorption d'une radiation actinique, par exemple une première couleur fondamentale de la lumière visible, et d'autre part désactivé par absorption d'une deuxième radiation actinique, par exemple au moins une autre couleur fondamentale de la lumière visible, complémentaire à la première couleur fondamentale

- et un composé photo-polymérisable, active sous l'effet de l'autre radiation actinique au moins, et inactivé sous l'effet de la première radiation actinique.

10 - Feuille selon la revendication 9, pour une reproduction en couleur, comportant trois ensembles de micro-capsules monochromes, correspondant à trois couleurs fondamentales respectivement, par exemple rouge, bleu et vert, disposés selon un seul et même revêtement, ou selon trois revêtements superposés correspondant aux trois ensembles respectivement, caractérisée en ce qu'à un ensemble monochrome donné correspond un couple donné agent colorant/composé photo-polymérisable, le premier étant activé par une couleur fondamentale donnée, et désactivé par les autres couleurs fondamentales, et le second se photo-polymérisant de manière sélective sous éclairement des autres couleurs fondamentales.

11 - Feuille de reproduction sensible à une radiation actinique, comportant un substrat (2) en forme de feuille, un revêtement (3) sur au moins une face du substrat, comprenant des micro-capsules (4), chaque micro-capsule comportant une enveloppe (5) étanche susceptible de se rompre sous l'action d'un agent extérieur, comme une force d'écrasement, et un milieu intérieur (6) contenant un composé révélateur actif vis-à-vis de la reproduction, caractérisée en ce que le milieu intérieur comprend

- un agent colorant, d'une part activé par absorption d'une première radiation actinique, par exemple une première couleur fondamentale de la lumière visible, et d'autre part désactivé par absorption d'une deuxième radiation actinique, par exemple au moins une autre couleur fondamentale de la lumière visible, complémentaire à la première couleur fondamentale

- et un composé photo-polymérisable, activé sous l'effet de l'autre radiation actinique au moins, et inactivé sous l'effet de la première radiation actinique.

12 - Feuille selon la revendication 11, comportant trois ensembles de micro-capsules monochromes correspondant à trois couleurs fondamentales respectivement, disposés selon un seul et même revêtement, ou selon trois revêtements superposés correspondant aux trois ensembles respectivement, caractérisée en qu'à un ensemble monochrome donné correspond un couple donné agent colorant/composé photo-polymérisable, le premier étant activé par une couleur fondamentale donnée, et désactivé par les autres couleurs fondamentales, et le second se photo-polymérisant de manière sélective sous éclairement des autres couleurs fondamentales

13 - Procédé de reproduction d'une image à partir d'un original (10), selon lequel on utilise une feuille de reproduction (1), sensible à une radiation actinique, comportant un substrat (2) en forme de feuille, un revêtement (3) sur au moins une face du susbstrat, comprenant des micro-capsules, chaque micro-capsule comprenant une enveloppe étanche (5) susceptible de se rompre sous l'action d'un agent extérieur, et un milieu intérieur (6) liquide contenant un composé révélateur actif vis-à-vis de la reproduction, procédé selon lequel on projette l'image sur le revêtement sensible (3), moyennant quoi pour les micro-capsules (4a) éclairées localement, on active le composé révélateur, puis on rompt les micro-capsules, moyennant quoi le composé révélateur activé est libéré localement vers l'extérieur, caractérisé en ce qu'on rompt les micro-capsules par absorption de ces dernières d'un rayonnement électro-magnétique hyper-fréquence, dit rayonnement micro-onde, lequel est utilisé comme révélateur

14 - Dispositif de reproduction d'une image, utilisant une feuille de reproduction (1) sensible à une radiation actinique, comportant un substrat (2) en forme de feuille, un revêtement (3) sur au moins une face du substrat, comprenant des micro-capsules (4), chaque micro-capsule comprenant une enveloppe étanche (5) susceptible de se rompre sous l'action d'un agent extérieur, et un milieu intérieur (6) liquide contenant un composé révélateur actif vis-à-vis de la reproduction, dispositif comportant un moyen (13) d'insolation ou exposition d'une image sur le revêtement (3) sensible de la feuille de reproduction, et un moyen (11,12) de révélation de la feuille insolée, permettant de rompre les micro-capsules, caractérisé en que le moyen de révélation consiste en une cavité (12) d'exposition à un rayonnement micro-onde, alimentée par un générateur (11) hyper-fréquence, du type magnétron.

FIG.1

FIG.2

## FIG_3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | CHEMICAL ABSTRACTS, vol. 93, no. 15, 13 octobre 1980 Columbus, Ohio, USA Academia Sinica: "Preparation and application of cholesterol type liquid crystalmicrocapsule membrane" page 589; colonne 2; ref. no. 159126N * abrégé * | 1-4 | B41M5/165 G03F7/00 B41M5/28 |
| Y | | 1-14 | |
| X,Y, D | GB-A-2113860 (THE MEAD CORPORATION) * page 3, lignes 39 - 46 * * page 5, lignes 40 - 50 * * page 8, lignes 1 - 2 * | 1-14 | |
| Y,D | FR-A-2516269 (THE MEAD CORPORATION) * page 8, lignes 13 - 22 * | 1-14 | |
| Y | EP-A-279104 (SEIKO INSTRUMENTS INCORPORATED) * le document en entier * | 1-14 | |
| Y,D | EP-A-164931 (THE MEAD CORPORATION) * le document en entier * | | **DOMAINES TECHNIQUES RECHERCHES (Int. Cl.5 )** |
| A | US-A-3936573 (B.W. BROCKETT) * le document en entier * | 1-14 | B41M G03F |
| A,D | H.F. Mark, D.F. Othmer et al.: "Kirk-Othmer Encyclopedia of Chemical Technology, Edition 3" no. 15, 1989, Wiley and Sons, New_York, U.S.A. * page 505, ligne 1 - page 509, ligne 14 * | 1-14 | |

Le présent rapport a été établi pour toutes les revendications

| Lieu de la recherche | Date d'achèvement de la recherche | Examinateur |
|---|---|---|
| LA HAYE | 28 AOUT 1990 | BACON A.J. |